Europäisches Patentamt

European Patent Office

Office européen des brevets

(11) Publication number: **0 557 668 A1**

## EUROPEAN PATENT APPLICATION

(21) Application number: **92480029.5**

(22) Date of filing: **26.02.92**

(51) Int. Cl.5: **H03K 19/0185**, H03K 19/00, H03K 5/15

(43) Date of publication of application:
**01.09.93 Bulletin 93/35**

(84) Designated Contracting States:
**DE FR GB IT**

(71) Applicant: **International Business Machines Corporation**
**Old Orchard Road**
**Armonk, N.Y. 10504(US)**

(72) Inventor: **Cederbaum, Carl**

**6, rue Général Pershing**
**F-78000 Versailles(FR)**
Inventor: **Girard, Philippe**
**Bat. A2, 71, rue Dauphine**
**F-91100 Corbeil Essonnes(FR)**

(74) Representative: **Klein, Daniel Jacques Henri**
**Compagnie IBM France Département de Propriété Intellectuelle**
**F-06610 La Gaude (FR)**

(54) **Low power TTL/CMOS receiver circuit.**

(57) The TTL/CMOS receiver circuit (15) biased between first and second supply voltages (VH, GND) includes an input or first stage (16) comprised of a standard inverter formed by two complementary FET devices (P1, N1) with an intermediate NFET (N2) coupled therebetween thus defining first and second common nodes (C, D). The second stage (18) is formed by a NFET (N4) and a PFET (P2) connected in series with a third common output node (E) coupled therebetween whose gate electrodes are drive by the potentials of these first and second common nodes (C, D) respectively. The said third common node (E) is connected to the gate electrode of a pull-up PFET (P3) mounted in series with a pull-down NFET (N5) therefore defining a fourth common node (F) therebetween which is connected to the gate electrode of said intermediate NFET (N2) in the input stage (16) by a first feedback loop connection (20). The gate of the pull-down NFET (N5) is connected to the common gate electrode of said inverter. Another feedback PFET device (P4) is connected between said third common node (E) and said first supply voltage (VH), whose gate electrode is connected to said fourth common node (F). The pull-up, pull-down and feedback FET devices (P3, N5, P4) constitute the third stage (19). The receiver circuit (15) further includes a fourth stage (21) comprised of two active complementary FET devices (P5, N6) connected in series and defining a fifth common node (G). The active NFET (N6) is loaded by a,resistively-connected PFET (P6) and its gate electrode is connected to said third common node via a second feed-back loop (22). On the other hand, the active PFET device (P5) has its drain region connected to said first common node (C) and its gate electrode is connected to the said common gate electrode. These three FET devices (P5, N6, P6) operate as the pull-up branch of the TTL/CMOS receiver. The input signal (Vin) received at the input terminal (17) is applied to the said common gate electrode. Finally, an inverting buffer (I5, I6) is connected to each of said third and fourth common nodes (E, F) to deliver the buffered complement and true output signals ($\overline{Vout}$, Vout) at their respective output terminals (24, 23).

The use of the said feedback loops permits to significantly decrease the DC current in the input stage (16) of the receiver circuit (15). In addition, it also improves the AC consumption but less significantly. Finally, it reduces delay variations between the input and the output signals and thereby improving the signal symmetry between the two phases of the output signal.

EP 0 557 668 A1

**FIG.2**

The present invention relates to CMOS logic circuits and more particularly to a low power TTL/CMOS receiver circuit.

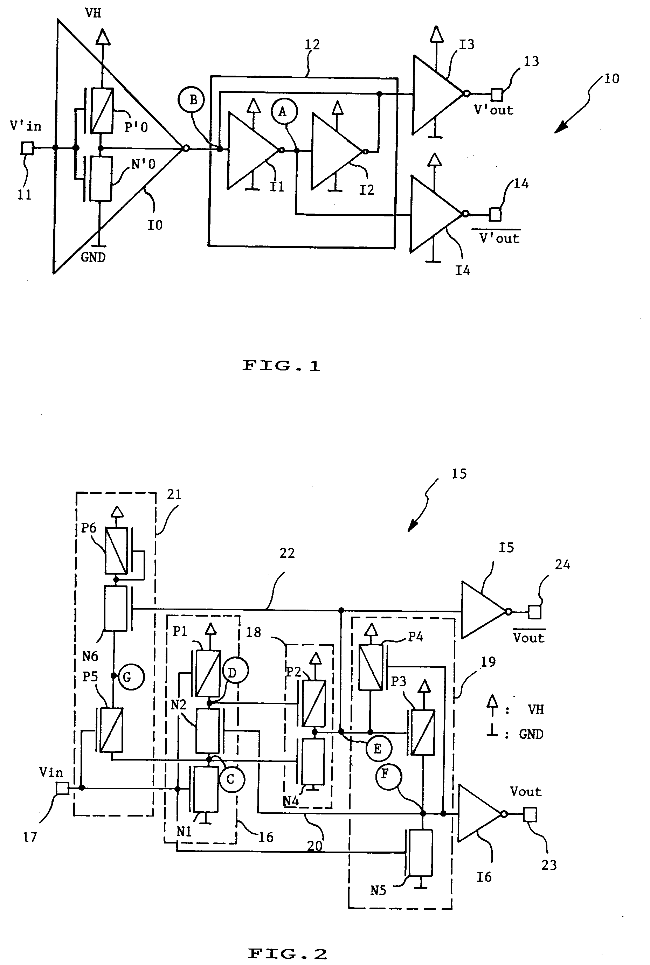

TTL components are extensively used in standard electronic boards while CMOS technology is more and more chosen to implement complex logic/memory functions into semiconductor chips. A major concern is that the high and low voltage levels in TTL circuits are different than those in CMOS circuits. For example, typical TTL circuits operate with standard high and low voltages of approximately 2,2 and 0,8 volts respectively, while typical CMOS circuits operate with high and low voltages of about 5 and 0 volts respectively. As a result, in order to couple the output of a TTL circuit to the input of a CMOS circuit, a converting circuit is commonly employed to change the logic levels. Conversion from TTL levels to CMOS levels is conventionally realized with CMOS on-chip receivers. These CMOS receiver circuits suffer from a high DC current flowing in the input branch when the input TTL signal is at the high level, as it will be illustrated in conjunction with the conventional TTL/CMOS receiver circuit 10 shown in Fig. 1.

As apparent from Fig. 1, the first stage is made by inverter I0 that amplifies the logic input signal V'in received at input terminal 11. The amplified signal is latched in a latch 12 which consists of two inverters I1 and I2 connected in series whose respective inputs and outputs are interconnected as standard. Complementary signal phases are generated and enforced at full-swing levels on nodes A and B. Finally, buffered true and complement output signals V'out and $\overline{V'out}$ are delivered via inverting buffers I3 and I4 at output terminals 13 and 14 respectively. All above mentioned inverters and buffers are conventionally comprised of a pair of complementary FET devices as illustrated in Fig. 1. They are all biased between a first supply voltage VH typically VH = 5 volts and a second supply voltage typically the ground (GND).

The main drawback of this conventional solution occurs when input signal V'in is at the TTL high level, i.e. around 2.2 Volts, which is not high enough to completely turn off PFET P'0 of inverter I0 while NFET N'0 is saturated. In this instance, the gate to source voltage Vgs(P'0) is about 2.8V. As a result, a few mA DC current is produced in the quiescent state which flows through these two FET devices.

In addition, the conventional circuit of Fig. 1 is recognized to exhibit large delay variations or dispersions between the input and output signals which in turn, results in a poor signal symetry between the two phases of the output signal for both the rising and the falling transitions of the input signal.

Therefore, it is a primary object of the present invention to provide a low power TTL/CMOS receiver circuit that consumes substantially no DC current in the quiescent state.

It is another object of the present invention to provide a low power TTL/CMOS receiver circuit that has minimal delay variations between the input and the output signals.

According to the basic principle of the present invention, the TTL/CMOS receiver circuit disclosed herein, uses feedback loops to decrease the DC current flowing in the input stage of the receiver circuit when the input signal is at the high level. In addition, it also improves the AC consumption but less significantly. Finally, it reduces delay variations between the input and the output signals and thus improves the symmetry between the true and complement phases of the output signal.

The novel TTL/CMOS receiver circuit is biased between first and second supply voltages. It first includes an input or first stage comprised of a standard inverter formed by two complementary FET devices with an intermediate NFET coupled therebetween thus defining first and second common nodes. The second stage is formed by a NFET and a PFET connected in series with a third common output node coupled therebetween whose gate electrodes are driven by the potentials of these first and second common nodes respectively. The said third common node is connected to the gate electrode of a pull-up PFET mounted in series with a pull-up down NFET, therefore defining a fourth common node therebetween which is connected to the gate electrode of said intermediate NFET in the input stage by a first feedback loop connection. The gate of the said pull-down NFET is connected to the common gate of said inverter in the first stage. A feedback PFET device is connected between said third common node and said first supply voltage, whose gate electrode is connected to said fourth common node. The pull-up, pull-down and feedback FET devices constitute the third stage.

The receiver circuit further includes a pull-up circuit comprised of two active complementary FET devices connected in series and defining a fifth common node coupled therebetween. The active NFET is loaded by a resistively-connected PFET. Its gate electrode is connected to said third common node via a second feed-back loop. On the other hand, the active PFET device has its drain region connected to said first common node. Theses three FET devices constitute the fourth stage of the TTL/CMOS receiver circuit. The input signal received at the input terminal is applied both to the gate electrode of the above mentioned active PFET and to the common gate electrode of said inverter in the first stage..

Finally, an inverting buffer is preferably connected to each of said third and fourth common nodes as standard, to deliver the buffered complement and true output signals at their respective output terminals.

The novel features believed to be characteristic of this invention are set forth in the appended claims. The invention itself, however, as well as other objects and advantages thereof, may best be understood by reference to the following detailed description of an illustrated preferred embodiment to be read in conjunction with the accompanying drawings.

Fig. 1 shows a conventional TTL/CMOS receiver circuit which generates the true and complement output signals at the CMOS levels from an input signal at the TTL levels.

Fig. 2 shows the novel TTL/CMOS receiver circuit of the present invention which also generates the true and complement CMOS output signals from an input signal at the TTL levels.

Fig. 3 illustrates the signal waveforms at various nodes/terminals of the novel TTL/CMOS receiver circuit for an input rising transition of the TTL input signal.

Fig. 4 illustrates the signal waveforms at various nodes/terminals of the novel TTL/CMOS receiver circuit for an falling transition of the TTL input signal.

A schematic of the novel TTL/CMOS receiver circuit of the present invention is shown in Fig. 2 and bears reference numeral 15. The receiver circuit is biased between first and second supply voltages respectively VH and GND. The input stage 16 is made of three FET devices P1, N1, and N2. FET devices P1 and N1 form an inverter with the said NFET N2 coupled therebetween thereby defining two common nodes C and D. The input signal Vin received on input terminal 17 is applied to the common gate electrode of said inverter. A second stage 18 is made of two FET devices P2 and N4 connected in series with common node E coupled therebetween. Gate electrodes of FET devices N4 and P2 are connected to said nodes C and D respectively. A third stage 19 is made of FET devices P3, P4 and N5. Pull-up and pull-down FET devices P3 and N5 are connected in series with common node F coupled therebetween. The potential of node F controls NFET N2 via a first feedback loop connection 20, while the gate electrode of NFET N5 is connected to the input terminal 17. Feedback PFET P4 is connected between node E and VH, its gate electrode is tied to node F. Receiver circuit 15 further comprises a pull-up circuit 21 forming the fourth stage thereof, made of FET devices P5, P6 and N6 connected in series. NFET N6 is loaded by resistively-mounted PFET P6 and has its gate electrode driven by the potential of node E via a second feedback connection 22. The common node between FET devices N6 and P5 is referenced G.

The signals that are generated at nodes F and E drive two conventional CMOS inverters I6 and I5 that deliver the buffered true and complement phases Vout and $\overline{V}out$ of the output signals at respective output terminals 23 and 24. In the quiescent state, operation of the novel TTL/CMOS receiver illustrated in Fig. 2 reads as follows.

When input signal Vin is low, NFETs N1 and N5 are cut off, while PFETs P1 and P5 are completely turned on. Potential on node F is high because NFET N5 is cut-off, which turns on NFET N2 via feedback loop 20, and in turn, renders NFET N4 conductive. As a result, the potential at node E is low. A low potential at node E cuts-off NFET N6 via feedback loop 22. Therefore, potential on node C is equal to potential on node D, i.e. is high because it is equal to VH (PFET P1 is on) minus a VT drop into NFET N2. Potential of node G is equal to the one of node C because PFET P5 is conducting. The potential of node D cuts off PFET P2 while NFET N4 clamps node E to GND. This implies that NFET N6 is turned off and PFET P3 turned on, leading to said high potential on node F as mentioned above.

When input signal Vin is high, NFETs N1 and N5 are turned on. Therefore, nodes C and F are tied to GND. This implies that PFET P4 is turned on, and holds node E to the high level VH. NFET N6 is turned on via feedback loop 22 and NFET N2 is turned off via feedback loop 20. Therefore, the inverter in the input stage 16 has its nodes C and D disconnected. Node D is held to VH through PFET P1 which is conducting because input signal Vin is not high enough to turn it off completely. In the fourth stage 21, each FET device is conductive, but PFET P5 has only a low Vgs equal to Vin minus the potential at node G, thus limiting the DC current in the input stage 16.

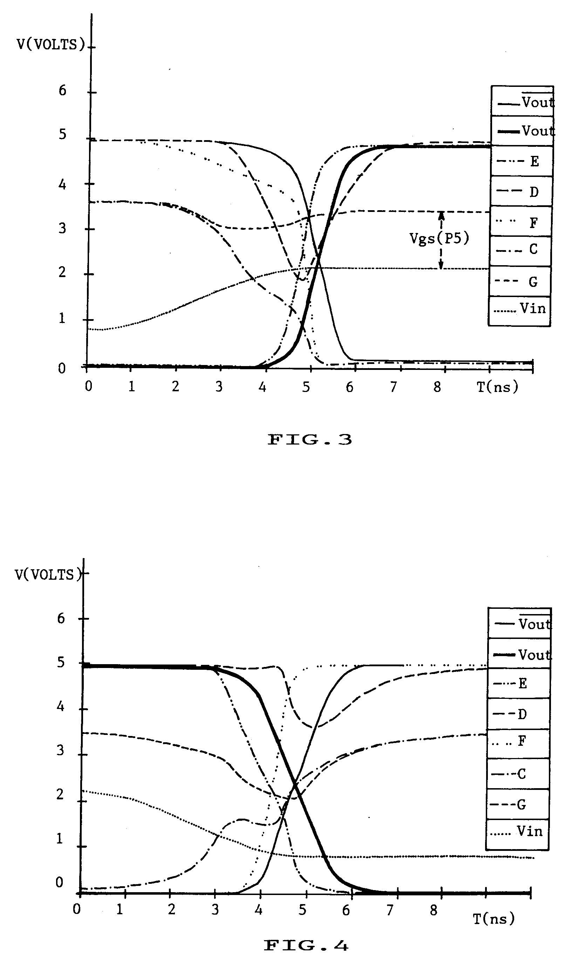

Dynamic operation of circuit 15 of Fig. 2 will be better understood in conjunction with the waveforms illustrated in Figs. 3 and 4 which show the potential/signals at various internal nodes/terminals for a rising and a falling transition of the input signal Vin respectively.

Now turning to Fig. 3, when the input signal rising transition occurs, NFET N1 which becomes on, discharges nodes C and D (through NFET N2). The potential on node F is slowly decreasing because PFET P3 is on. When the potentials of nodes C and D are low enough, node E potential rises and turns on NFET N6. The signal on node G that has started to slowly fall down through PFET P5 and NFET N1, is now held to around 3.5 volts through PFET P6 and NFET N6. When the input signal is high, this results in a low Vgs voltage of PFET P5, thereby reducing the DC current in NFET N1 in the first stage as explained above. When node E potential reaches VH minus VT (P3), it turns off PFET P3 in the third stage, accelerating thereby the falling of node F potential through NFET N5, and cutting off NFET N2 in the input stage. As a result, node D potential stops falling and returns to VH through PFET P1. Therefore, at the end of the rising transition, FET devices P2 and N4 are turned off, and PFET P4, is on, thus insuring a high level on node E. At the end of the rising transition, the potential of nodes C and F is low and the potential of nodes D and E is high. It may be noticed that PFET P5 is biased between VH-1.5 V and node C which is at the GND, as a result, Vgs(P5) = 1.3V, which is to be compared with Vgs(P'0) = 2.8V mentioned above.

The effects of the input signal falling transition will be considered in the light of Fig. 4. When it occurs, NFET devices N1 and N5 are first turned off, meanwhile PFET P5 is slowly turned on, which helps rising the potential of node C. When node C potential is sufficiently high, node E potential falls down through NFET N4, because PFET P4 is not strong enough to maintain it at a high level. When node E potential is low enough, it turns on PFET P3, which in turn, pulls up node F towards VH, and thus cuts off PFET P4 thereby speeding up the falling of node E potential. The potential increase of node F also turns on NFET N2, which in turn helps the rising of node C potential through PFET P1. After a small negative undershoot, due to NFET N2 which is turned on, node D potential is held high by PFET P1. Node G potential becomes equal to node C potential through PFET P5. At the end of the falling transition, potential of nodes C, D and F is high and the potential at node E is low.

Receiver circuit 15 has been designed for a CMOS stand-alone Static Random Access Memory (SRAM) chip. Simulations using standard models have been conducted to compare the performance of receiver circuits of Figs. 1 and 2 once implemented in an advanced CMOS technology. Parasitic drain-substrate and source-substrate capacitances have been added for each FET device. Output terminals were loaded by the same RC structure. Results of comparison are detailed below for AC and DC current consumptions and delays between the input and the output signals. Comparison has been extended to the best and worst cases in addition to the nominal case because improvements are sometimes more significant in the former cases than in the latter one.

The following operating conditions, respectively defined for the best, nominal, and worst process parameters have been adopted:

Best case:
VH = 5.5Volts - Temp = 15C
Nominal case:
VH = 5.0Volts - Temp = 50C
Worst case:
VH = 4.5Volts - Temp = 85C

1) DC and AC Consumption

In the following TABLE I, the AC and DC currents, respectively referred to as Iac and Idc (in mA) for the conventional receiver circuit 10 and the novel receiver circuit 15 of the present invention are listed. The DC current Idc consumed by the receiver circuits is measured for an input signal at the high level (i.e. Vin = 2.2 V), for the three best, nominal and worse cases. The AC current Iac is measured at 40 MHz for an alternative signal whose amplitude varies between the low level (0.8V) and the high level (2.2V) of the TTL standard.

TABLE I

| Idc (mA) | best case | nom. case | worst case |
|---|---|---|---|
| circuit 10 | 1.85 | 0.97 | 0.46 |
| circuit 15 | 0.29 | 0.09 | 0.005 |
| Iac (mA) | best case | nom. case | worst case |
| circuit 10 | 1.56 | 0.97 | 0.63 |
| circuit 15 | 0.91 | 0.60 | 0.45 |

These values show that the receiver circuit 15 decreases the maximum DC current by a 6 times ratio in the best case conditions. The ratio is even more important under nominal and worst case conditions. Moreover, circuit 15 also decreases the AC current consumption between about 30 and 40%.

When the input signal Vin is at the low level (Vin = 0.8 V), the DC currents of the two receiver circuits are in the same order of magnitude, i.e. 40 to 80 $\mu$A which is negligible.

2) Delay variations and signal symmetry

A comparison in terms of delays and signal symmetry between circuit 10 of Fig. 1 and circuit 15 of Fig. 2 is given in TABLE II.

In TABLE II, delays are listed for a rising transition (0.8V to 2.2V) and a falling transition (2.2V to 0.8V) of the input signal Vin, respectively referred to as Delay ↑ and Delay ↓. The delay is measured between input middle swing (1.5V) and crosspoint of true and complement output signals Vout and $\overline{Vout}$. To better emphasize the differences between the two receiver circuits, voltage values at crosspoints are also given for both rising and falling transitions. There are referred to in TABLE II as V(Xpoint ↑) and V(X point ↓) respectively.

## TABLE II

### Circuit 10 of Fig. 1

|  | best case | nom. case | worst case |
| --- | --- | --- | --- |
| Delay↑ | 2.73 ns | 2.70 ns | 2.81 ns |
| Delay↓ | 1.61 ns | 2.33 ns | 3.43 ns |
| V(Xpoint↑ ) | 4.26 V | 3.82 V | 3.41 V |
| V(Xpoint↓ ) | 1.88 V | 1.58 V | 1.37 V |

### Circuit 15 of Fig. 2

|  | best case | nom. case | worst case |
| --- | --- | --- | --- |
| Delay↑ | 2.35 ns | 2.72 ns | 3.27 ns |
| Delay↓ | 1.58 ns | 2.12 ns | 3.31 ns |
| V(Xpoint↑ ) | 1.88 V | 2.02 V | 2.14 V |
| V(Xpoint↓ ) | 1.76 V | 2.65 V | 2.82 V |

As apparent from TABLE II, receiver circuit 15 offers less variation or dispersion between rising and falling delays when compared to receiver circuit 10. It gives a reduced variation of delays and a small improvement of the maximum values thereof. For example, with receiver circuit 10, the maximum delay variation value is about 1.12 ns to be compared with a value of 0.77 ns with the receiver circuit 15 (best case conditions for both). Finally, as apparent from TABLE II, it also offers highly symetric output phases while the conventional receiver 10 of Fig. 1 has different voltages at crosspoints that comes from the mismatching between true and complement output signals. The maximum difference value is 2.36V for the receiver circuit 10 in the base case conditions, to be compared with a value of 0.68V for the receiver circuit 15 (in the worst case conditions). High voltage values at crosspoints implies overlapping of output signals that can for example, lead to the multiple selection of decoders in a SRAM chip. The values of TABLE II confirm the excellent symetry of both phases of the output signal irrespective of the type of the transition as illustrated in Figs. 3 and 4.

3) Hysteresis and DC noise margins.

Both receiver circuits exhibit similar values for hysteresis (about 500 mV) and DC noise margins (700mV to 1200mV depending upon external conditions and input voltage levels). The receiver circuit of Fig. 2 can advantageously replace conventional TTL to CMOS receivers in memory, ASIC or custom chips where low power consumption is of paramount importance. In particular, SRAM chips which are more and more often used in low power applications, can take advantage of the receiver circuit of Fig. 2 to decrease

6

the overall chip DC current.

**Claims**

1. TTL/CMOS receiver circuit (15) biased between first and second supply voltages (VH, GND) characterized in that it includes:

   an input or first stage (16) comprised of a standard inverter formed by two complementary FET devices (N1, P1) having a common gate electrode with an intermediate NFET (N2) coupled therebetween thus defining first and second common nodes (C,D);

   a second stage (18) formed by a NFET (N4) and a PFET (P2) connected in series with a third common output node (E) coupled therebetween whose gate electrodes are driven by the potentials of these first and common nodes respectively;

   a third stage (19) comprising a PFET (P3) connected in series with a NFET (N5), with a fourth common node (F) coupled therebetween; the latter is connected to the gate electrode of said intermediate NFET (N2) in the input stage by a first feedback loop connection (20); the gate of the NFET (N5) is connected to the common gate of said inverter; the said third common node (E) is connected to the gate electrode of said PFET (P3); said third stage further comprising a PFET (P4) device connected in parallel between said third common node (E) and said first supply voltage (VH), whose gate electrode is connected to said fourth common node (F);

   a fourth stage (21) comprised of two active complementary FET devices (P5, N6) connected in series and defining a fifth common node (G); the active NFET (N6) is loaded by a resistively-connected PFET (P6) and has its gate electrode is connected to said third common node (E) via a second feed-back loop (22); the active PFET (P5) device has its drain/source region connected to said first common node (C) and its gate electrode connected to the common gate electrode of the said inverter; and,

   an input terminal (17) where the input signal (Vin) is received connected to the common gate electrode of said inverter.

2. The TTL/CMOS receiver circuit of claim 1 further including an inverting buffer (I5, I6) connected to each of said third and fourth common nodes (E/E) to deliver the buffered complement and true output signals ($\overline{\text{Vout}}$, Vout) at their respective output terminals (24, 23).

FIG.1

FIG.2

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-2 197 558  (SILICON SYSTEMS INC.) <br> * whole document * <br> --- | 1 | H 03 K  19/0185 <br> H 03 K  19/00 <br> H 03 K   5/15 |
| A | US-A-4 929 852  (M.H. BAE) <br> * figures 3,4; column 1, line 64 - column 2, line 7 * <br> --- | 1 | |
| A | US-A-4 672 243  (H.C. KIRSCH) <br> * figure 3; abstract * <br> --- | 1 | |
| A | EP-A-0 386 570  (INTEGRATED DEVICE TECHNOLOGY INC) <br> * figure 3; abstract * <br> --- | 1 | |
| A | IBM TECHNICAL DISCLOSURE BULLETIN vol. 32, no. 12, May 1990, pages 411-413; "High Performance CMOS Receiver Circuit for Interfacing with TTL, ECL, NMOS or CMOS Logic Circuits" <br> * whole document * <br> ----- | 1 | |

TECHNICAL FIELDS
SEARCHED (Int. Cl.5)

H 03 K   5/15
H 03 K  19/00
H 03 K  19/0185

The present search report has been drawn up for all claims

| Place of search | Date of completion of the search | Examiner |
|---|---|---|
| BERLIN | 30-10-1992 | ARENDT M |